# EUROPEAN PATENT APPLICATION

(11) **EP 3 428 671 A1**
(43) Date of publication of application: **16.01.2019**
(21) Application number: 17180632.6
(22) Date of filing: 11.07.2017
(51) Int. Cl.: G01R 33/34, G01R 33/36, G01R 33/48, G01R 33/565

(54) **RF FEED CIRCUIT FOR MAGNETIC RESONANCE IMAGING**

(71) Applicant: Koninklijke Philips N.V., 5656 AE Eindhoven (NL)
(72) Inventor: UHLEMANN, Falk, 5656 AE Eindhoven (NL)
(74) Representative: de Haan, Poul Erik

(57) **Abstract**

The invention provides for a medical instrument (100) comprising a magnetic resonance imaging system (104) with an imaging zone (132) and a radiotherapy system (102) configured for irradiating a target zone (138) with a radiation beam (142). The target zone is within the imaging zone. The magnetic resonance imaging system comprises a main magnet (112) with a bore (122) for receiving a subject (136), wherein the imaging zone is within the bore, wherein the bore connects a first entrance (154) and a second entrance (156), wherein the radiation beam defines at least one path through the bore. The magnetic resonance imaging system further comprises a magnetic gradient coil (124) within the bore. The magnetic resonance imaging system further comprises a tubular body coil (129) within the bore. The tubular body coil is surrounded by the magnetic gradient coil. The magnetic resonance imaging system further comprises an RF screen (144) between the magnetic gradient coil and the tubular body coil. The magnetic resonance imaging system further comprises an RF system (130) for providing RF power to the tubular body coil. The magnetic resonance imaging system further comprises an RF feed circuit (146) positioned between the tubular body coil and the RF screen. The RF feed circuit is located within the bore. The RF feed circuit comprises one or more RF power feeds (148, 148') adjacent to the first entrance. The RF power feeds are configured for connecting to the RF system. The tubular body coil further comprises one or more pairs of matching networks (150, 150') for coupling the one or more RF power feeds to the tubular body coil. Each of the one or more pairs of matching networks comprises a first matching network located between the first entrance and the at least one path and a second matching network located between the second entrance and the at least one path. The RF feed circuit comprises at least one transmission line (152). The at least one transmission line is formed from a laminated circuit board (600, 700). Each of the one or more pairs of matching networks is connected by one of the at least one transmission line.

## Description

### FIELD OF THE INVENTION

The invention relates to magnetic resonance imaging.

### BACKGROUND OF THE INVENTION

Integration of Magnetic Resonance Imaging (MRI) and Linear Accelerators (LINAC) opens new horizons in radiotherapy by improved lesion targeting, especially for moving organs. In a practical implementation proposal, the LINAC rotates around the subject to hit the gross target volume (GTV) and clinical target volume (CTV) from multiple angles while minimizing the radiation exposure for surrounding tissues.

The combination of magnetic resonance apparatuses and LINAC radiotherapy sources is known. Typically, a LINAC source is placed on a rotating gantry about the magnet and the magnet designed such that the LINAC rotates in a zero-field region of the magnet.

International patent application WO 2016/034364 discloses a magnetic resonance antenna. The magnetic resonance antenna is a surface coil and is a receive coil. The magnetic resonance antenna comprises one or more antenna elements. The magnetic resonance antenna further comprises a preamplifier for the antenna element and a coil former for supporting the antenna element. The coil former is formed from a porous material. The antenna is divided into an irradiation zone and at least one reduced radiation zone. The preamplifier for each of multiple antenna elements is located within the at least one reduced radiation zone. The multiple antenna elements are located at least partially within the irradiation zone.

### SUMMARY OF THE INVENTION

The invention provides for a medical instrument in the independent claims. Embodiments are given in the dependent claims.

Embodiments may provide for improved magnetic resonance imaging for the guidance of a radiotherapy system. Embodiments provide for a tubular body coil that has a RF power feed that couples RF power into pairs of matching networks. The matching networks are at opposite ends of the tubular body coil. Feeding RF into both ends of the tubular body coil provides for a more uniform B1 field. A difficulty in implementing such an RF power feed for a combined Magnetic Resonance Imaging (MRI) and radiotherapy system being fed from one side of the system is that transmission lines between the two ends can block or attenuate the radiation beam from the radiotherapy system. Embodiments may reduce or eliminate this problem by using a transmission line formed from a laminated circuit board.

In one aspect, the invention provides for a medical instrument comprising a magnetic resonance imaging system. The magnetic resonance imaging system has an imaging zone. The medical instrument further comprises a radiotherapy system configured for irradiating a target zone with a radiation beam. The target zone is within the imaging zone. The magnetic resonance imaging system may be configured for guiding the irradiation of the target zone. This may involve positioning a subject and/or changing the path of the radiation beam. The magnetic resonance imaging system comprises a main magnet with a bore for receiving a subject. The imaging zone is within the bore. The bore connects a first entrance and a second entrance. The radiation beam defines at least one path through the bore. The magnetic resonance imaging system further comprises a magnetic gradient coil within the bore. The magnetic resonance imaging system further comprises a tubular body coil within the bore. The tubular body coil could for example be a cylindrical body coil or an oval shaped body coil

The tubular body coil is surrounded by the magnetic gradient coil. The magnetic resonance imaging system further comprises an RF screen between the magnetic gradient coil and the tubular body coil. The magnetic resonance imaging system further comprises an RF system for providing RF power to the tubular body coil. The magnetic resonance imaging system further comprises an RF feed circuit positioned between the tubular body coil and the RF screen. The RF feed circuit is located within the bore. The RF feed circuit comprises one or more RF power feeds adjacent to the first entrance. The RF power feeds are configured for connecting to the RF system. The tubular body coil further comprises one or more pairs of matching networks for coupling the one or more RF power feeds to the tubular body coil. Each of the one or more pairs of matching networks comprises a first matching network located between the first entrance and the at least one path and a second matching network located between the second entrance at the at least one path. The RF feed circuit comprises at least one transmission line. The at least one transmission line is formed from a laminated circuit board. Each of the one or more pairs of matching networks is connected by one of the at least one transmission line.

This embodiment may be beneficial because feeding the tubular body coil at opposite ends may provide for a more uniform B1 field that is generated by the body coil. This may provide for a better quality magnetic resonance imaging and result in better guidance of the radiotherapy system using the magnetic resonance imaging system. This may also provide for a more modular RF transmit system employing multiple smaller RF amplifier each being connected to one of the said matching networks instead of e.g. one or two larger RF amplifiers whose power is distributed to e.g. one or two power feeding ports only. The use of the laminated circuit board may reduce the attenuation of the radiation beam by the at least one transmission line.

In another embodiment, the medical instrument further comprises a processor for controlling the medical instrument. The medical instrument further comprises a memory for storing machine-executable instructions for execution by the processor and the memory also stores pulse sequence commands. The pulse sequence commands as used herein encompass commands or data which can be translated into commands for executing data acquisition according to a magnetic resonance imaging protocol.

Execution of the machine-executable instructions causes the processor to control the magnetic resonance imaging system with the pulse sequence commands to acquire magnetic resonance data. Execution of the machine-executable instructions further cause the processor to control the radiotherapy system to irradiate the target zone. The control of the radiotherapy system is guided or modified using the magnetic resonance data. For example, the magnetic resonance data may be used to construct one or more magnetic resonance images that are then registered to a radiotherapy treatment plan. The combination of the magnetic resonance images and the radiotherapy plan may be used to generate control commands for the radiotherapy system to properly control it to irradiate the target zone.

In another embodiment, the laminated circuit board is formed from a laminate that comprises polyimide. Polyimide may have the advantage that it has superior resistance to both radiation and heat while being very thin and possibly flexible.

In another embodiment, the laminated circuit board is formed from a laminate that comprises phenolic.

In another embodiment the laminated circuit board is formed from a laminate of biaxially-oriented polyethylene terephthalate.

In another embodiment, the laminated circuit board comprises electrical connections or traces formed from copper.

In another embodiment, the laminated circuit board comprises traces or electrical connections formed from gold. Gold may for example be used in solid form or be used to plate copper.

In another embodiment, the laminated circuit board is further formed from traces or electrical connections formed from aluminum.

In another embodiment, the laminated circuit board is further formed from electrical connections or traces formed from silver. The sliver could for example be solid or used to plate copper.

The above mentioned metals which are electrical connectors may typically have a thickness between 18 µm and approximately 35 µm. The above mentioned insulators or laminate materials such as polyimide may be between about 0.5 and 1 mm thick.

In another embodiment, the laminated circuit board is flexible. This may be advantageous because it may facilitate the placement of the laminated circuit board between the RF screen and the tubular body coil.

In another embodiment, the laminated circuit board is attached to the RF screen. This embodiment may be beneficial because the laminated circuit board can then be installed into the magnetic resonance imaging system independent or separately from the tubular body coil.

In another embodiment, the at least one transmission line is a planar twisted pair. A planar twisted pair may also be referred to as an ultra-flat twisted pair. In a planar twisted pair two layers are used to generate traces that crisscross each other and are used to simulate a twisted pair of wires.

In another embodiment, the at least one transmission line is a system symmetric stripline. A symmetric stripline has two planar ground planes which surround two identical strip connectors that are next to each other.

In another embodiment, each of the one or more pairs of matching networks is coupled to the tubular body coil via a galvanic connection. The use of the galvanic connection may be beneficial in connecting the body coil for certain types of matching networks. This may be particularly beneficial when the laminated circuit board is flexible because this may facilitate the connection making the galvanic connection once the RF feed circuit and the tubular body coil are already installed into the bore of the main magnet.

In another embodiment, each of the one or more pairs of matching networks is coupled to the tubular body coil via an inductive coupling. The inductive coupling itself may function as the matching network.

In another embodiment, each of the one or more pairs of matching networks comprises an inductive coupling loop for coupling to the tubular body coil. The inductive coupling loop is formed from the laminated circuit board. In this example the entire RF feed circuit or only a portion of it is formed from the laminated circuit board. Having the inductive coupling loop formed from the laminated circuit board may reduce costs and the size of the RF feed circuit.

In another embodiment, the tubular body coil is a birdcage coil.

In another embodiment, the tubular body coil is a TEM coil.

In another embodiment, the one or more pairs of matching networks is at least partially formed from the laminated circuit board. For example, the matching network may be formed on the laminated circuit board and then populated with discreet components. In some instances, the discreet components may also be formed from the laminated circuit board, i.e. as distributed components.

In another embodiment, the one or more pairs of matching networks comprises inductors and/or capacitors. At least a portion of the inductors and/or capacitors are formed from the laminated circuit board.

In another embodiment, the one or more pairs of matching networks is connected to the at least one transmission line via a coaxial cable. For example, the coaxial cable may be located in the regions outside of where the radiation beam passes. This embodiment may be beneficial in connecting a large number of matching networks.

In another embodiment, the radiotherapy system is a LINAC.

In another embodiment, the radiotherapy system is an X-ray therapy system.

In another embodiment, the radiotherapy system is a charge particle therapy system.

In another embodiment, the radiotherapy system is a gamma radiation therapy system.

In another embodiment the radiotherapy system is a cobalt radiation therapy system.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, a data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a processor. Computer memory may be any volatile or non-volatile computer-readable storage medium.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the C programming language or similar programming languages and compiled into machine executable instructions. In some instances, the computer executable code may be in the form of a high level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, wireless local area network connection, TCP/IP connection, Ethernet connection, control voltage interface, MIDI interface, analog input interface, and digital input interface.

Magnetic Resonance (MR) data is defined herein as being the recorded measurements of radio frequency signals emitted by atomic spins using the antenna of a magnetic resonance apparatus during a magnetic resonance imaging scan. Magnetic resonance data is an example of medical imaging data. A Magnetic Resonance (MR) image is defined herein as being the reconstructed two or three dimensional visualization of anatomic data contained within the magnetic resonance imaging data.

### BRIEF DESCRIPTION OF THE DRAWINGS

In the following preferred embodiments of the invention will be described, by way of example only, and with reference to the drawings in which:
Fig. 1 illustrates an example of a medical instrument;
Fig. 2 illustrates an example of a RF feed circuit and a tubular body coil;
Fig. 3 illustrates a further example of a RF feed circuit and a tubular body coil;
Fig. 4 illustrates a further example of a RF feed circuit and a tubular body coil;
Fig. 5 illustrates a further example of a RF feed circuit and a tubular body coil;
Fig. 6 illustrates an example a transmission line;
Fig. 7 illustrates a further example a transmission line;
Fig. 8 shows a further view of the transmission line of Fig. 7;
Fig. 9 illustrates a galvanic connection between a tubular body coil and RF feed circuit; and
Fig. 10 shows an example of a bird cage coil with an inductive coupling to the RF feed circuit.

### DETAILED DESCRIPTION OF THE EMBODIMENTS

Like numbered elements in these figs are either equivalent elements or perform the same function. Elements which have been discussed previously will not necessarily be discussed in later figs if the function is equivalent.

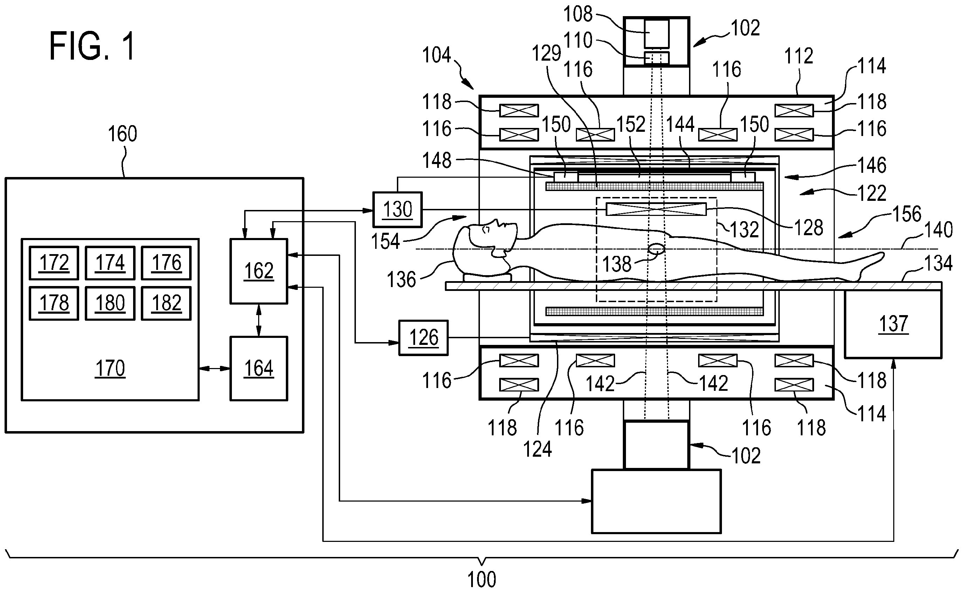

Fig. 1 illustrates an example of a medical instrument 100. The medical instrument 100 comprises a radiotherapy system 102 and a magnetic resonance imaging system 104. The radiotherapy system 102 comprises a gantry 106 and a radiotherapy source 108. The gantry 106 is for rotating the radiotherapy source 108 about an axis of gantry rotation 140. Adjacent to the radiotherapy source 108 is a collimator 110. The magnetic resonance imaging system 104 comprises a magnet 112. In Fig. 1, the radiotherapy system is a LINAC. The use of a LINAC is representative and could be replaced by other types of radiotherapy systems.

It is also possible to use permanent or resistive magnets. The use of different types of magnets is also possible for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils. Within the bore of the cylindrical magnet there is an imaging zone where the magnetic field is strong and uniform enough to perform magnetic resonance imaging.

The magnet 112 shown in this embodiment is a standard cylindrical superconducting magnet. The magnet 112 has a cryostat 114 with superconducting coils within it 116. There are also superconducting shield coils 118 within the cryostat also. The magnet 112 has a bore 122.

Within the bore of the magnet is a magnetic field gradient coil 124 for acquisition of magnetic resonance data to spatially encode magnetic spins within an imaging zone of the magnet. The magnetic field gradient coil 124 is connected to a magnetic field gradient coil power supply 126. The magnetic field gradient coil 124 is intended to be representative, to allow radiation to pass through without being attenuated it will normally be a split-coil design. Typically, magnetic field gradient coils contain three separate sets of coils for spatially encoding in three orthogonal spatial directions. The magnetic field gradient power supply 126 supplies current to the magnetic field gradient coils. The current supplied to the magnetic field coils is controlled as a function of time and may be ramped or pulsed.

There is a body coil 129 and an optional surface coil 128 connected to a transceiver 130. The surface coil 128 and the body coil 129 are adjacent to an imaging zone 132 of the magnet 112. The imaging zone 132 has a region of high magnetic field and homogeneity which is sufficient for performing magnetic resonance imaging. The surface coil 128 and the body coil may both be used for manipulating the orientations of magnetic spins within the imaging zone and for receiving radio transmissions from spins also within the imaging zone. The surface coil 128 and the body coil 129 may both also be referred to as an antenna or channel. The surface coil 128 and the body coil 129 may each contain multiple coil elements. The radio frequency antenna may also be referred to as a channel.

The surface coil 128 and the body coil 129 and the radio frequency transceiver 130 may be replaced by separate transmit and receive coils and a separate transmitter and receiver. It is understood that the surface coil 129 and the radio frequency transceiver 130 are representative. The radio frequency antenna is intended to also represent a dedicated transmit antenna and a dedicated receive antenna. Likewise, the transceiver may also represent a separate transmitter and receivers.

Also within the bore of the magnet 122 is a subject support 134 for supporting a subject 136. The subject support 134 may be positioned by a mechanical positioning system 137. Within the subject 136 there is a target zone 138. The axis of gantry rotation 140 is coaxial in this particular embodiment with the cylindrical axis of the magnet 112. The subject support 134 has been positioned such that the target zone 138 lies on the axis 140 of gantry rotation. The radiation source 108 is shown as generating a radiation beam 142 which passes through the collimator 303 and through the target zone 138. As the radiation source 108 is rotated about the axis 140 the target zone 138 will always be targeted by the radiation beam 142. The radiation beam 142 passes through the cryostat 114 of the magnet. The magnetic field gradient coil may have a gap which separate the magnetic field gradient coil into two sections. If present, this gap reduces attenuation of the radiation beam 142 by the magnetic field gradient coil 124. In some embodiments the magnetic resonance coil 128 may also have gaps or be separated to reduce attenuation of the radiation beam 142.

It can be seen that within the bore 122 of the magnet 112 there is a body coil 129. The bore 122 of the magnet has a first entrance 154 and a second entrance 156. Within the bore 122 is an RF shield 144. An RF feed circuit 146 is located between the RF shield 144 and the tubular body coil 129. The RF feed circuit 146 has an RF power feed 148 near the first entrance 154. The RF power feed 148 connects to the transceiver 130. The RF feed circuit 146 further comprises a pair of matching networks 150. The pair of matching networks 150 is connected by a transmission line 152. The transmission line is constructed from a laminated circuit board. The use of the pair of matching networks 150 feeds the tubular body coil 129 at both ends. This makes the B1 field more uniform. In this example there is only one pair of matching networks 150. There may however be multiple pairs of matching networks 150, multiple RF power feeds 148 and multiple transmission lines 152.

The transceiver 130, the magnetic field gradient coil power supply 126 and the mechanical positioning system 137 are all shown as being connected to a hardware interface 162 of a computer system 160. The computer system 160 is shown as further comprising a processor 164 for executing machine executable instructions and for controlling the operation and function of the therapeutic apparatus. The hardware interface 162 enables the processor 164 to interact with and control the medical instrument 100. The processor 162 is shown as further being connected to a computer memory 170.

The computer memory 170 is shown as containing machine-executable instructions 172 which enable the processor 164 to control the operation and function of the various components of the medical instrument 100. The computer memory 170 is further shown as containing pulse sequence commands 174, which enable the processor 164 to control the magnetic resonance imaging system 104 to acquire magnetic resonance data. The computer memory 150 is further shown as containing magnetic resonance data 156 that was acquired by controlling the magnetic resonance imaging system 104 with the pulse sequence commands 174. The computer memory 170 is further shown as containing the magnetic resonance image 178 that was reconstructed from the magnetic resonance data 176. The magnetic resonance image 178 may for example be used to guide radiotherapy using the radiotherapy system 102.

The computer memory 170 is further shown as containing a radiotherapy plan 180. The radiotherapy plan 180 may be a detailed plan to irradiate a portion of the subject 136. The computer memory 170 is further shown as containing radiotherapy system control instructions 182. The radiotherapy control instructions may be instructions that are able to control the radiotherapy system 102 to irradiate the target zone 138. The radiotherapy system control instructions 182 may be constructed using the radiotherapy plan 180 and the magnetic resonance image 178. For example, the magnetic resonance image 178 could be registered to the radiotherapy plan 180 and therefore used to guide the irradiation of the target zone 138.

RF field homogeneity of a body coil can be increased by increasing the number of feeding ports. The additional cables, their routing and matching components are especially critical in the context of the MR-Linac device.

Examples may use a thin (i.e. radiation transparent) polyimide-and copper-based (i.e. radiation-hard) multi-layer design (a laminated circuit board), to distribute the RF power and feed it into the body coil either inductively or galvanically.

This approach may minimize the number of components needed for RF body coil power feeding/matching, allows more efficient and reproducible production.

The RF-field homogeneity of the MR-Linac body coil and thus the image quality can be improved using examples describe herein. For example, by using an RF feed circuit that provides for a 2-port or 4-port feeding to the body coil.

The additional cabling and components required for the additional feeding ports pose numerous problems when realized in "conventional" ways especially in the context of the MR-Linac:
Semi-rigid coaxial power cable (current feeding cabling):
   - Connection between cable and matching board has to be mechanically stable (glued and soldered)
   - crossing the radiation window causes radiation field inhomogeneity
   - normal coaxial cable is not radiation hard
Feeding traces integrated into RF screen:
   - Requires additional layers in already expensive large RF screen PCB
   - Losses of FR4 based PCBs are higher than coaxial cables
   - Possible reliability and safety issues due to high quality requirements on an exceptionally large PCB structure
   - Additional connections at input (power connectors of coil) and output (coupling loops) required
   - Inductive feeding loops at the end of feeding cable to couple into body coil:
   - tedious assembly/soldering with high required precision
   - pre-assembly of feeding difficult because loop is soldered directly to body coil PCB which holds power caps and is glued to body coil carrier

In one example, the placement of a separate polyimide/phenolic- and copper-based laminate structure in close proximity to the RF screen with integrated input connection pads and inductive output coupling loops is realized.

This dedicated part enables a cost efficient modular design with low electrical losses and high radiation transparency for an increased/arbitrary number of feeding ports to improve RF homogeneity.

Depending on the number/location of used feeding-ports the proposed feeding/matching may have different geometric realizations. But since the long-term goal of the body coil design is a convergence of these options, prospectively only one design needs to be created and maintained. Regardless of the specific geometry the following design rules are applied:
Multi-layered design to incorporate inductors/capacitors for matching circuit and feeding (strip-) line using for example (low loss) Polyimide-copper structures
Matching circuit can be made adjustable by "scratch-through" paths, i.e. no trial-and-error/iterative soldering of capacitors
Capacitor and inductor layouts with minimal coupling to RF coil, e.g. correctly oriented meander and/or twisted lines
Footprint of the component should be as small as possible to lower costs, reduce buckling during attachment of component of body coil carrier using glue
Parts of the component with supporting function can be made of epoxy/phenol based glass laminates (to save cost)
Component thickness as low as possible to reduce mounting effort and radiation absorption, especially in irradiated zone
Size and design can be adapted to "any" number of feeding ports and respective locations (below illustrated for two ports (only front side visible) and one-sided feeding)

Below the front-side of such a flexible PCB for a 4-port feeding is illustrated (back side symmetric but not visible/shown). To reduce the unwanted coupling between the feeding line part and the resonator it should be placed as close as possible to the RF screen, e.g. either pressed by placing the feeding line on elevated structures of the carrier and holding it down by the mounted screen or by gluing it to the screen. The first option has the advantage of being completely detached from the screen to enable easy re-assembly, the second implementation allows to pre-assemble screen and feeding structure but requires (detachable) connections to the power connectors and carrier.

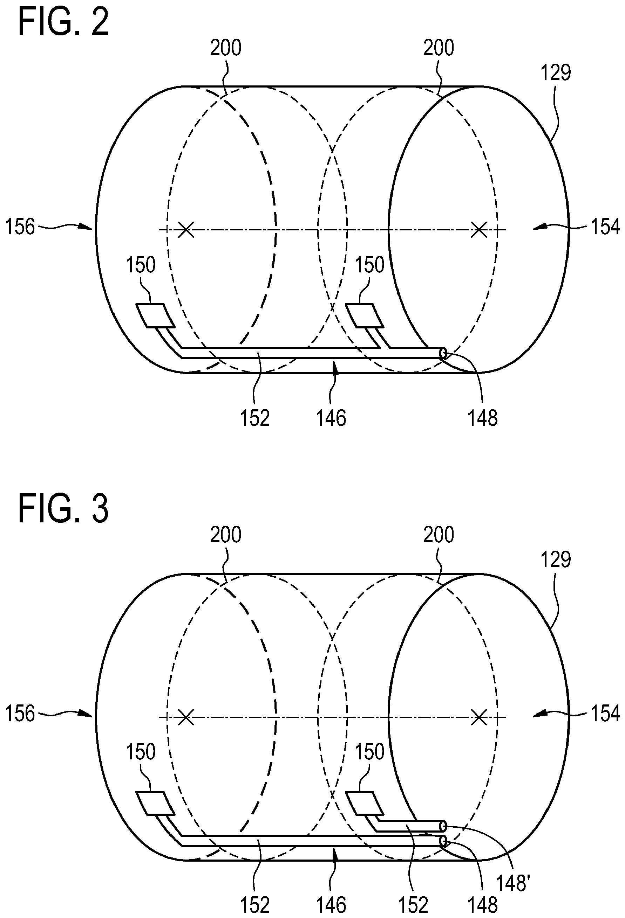

Fig. 2 shows an example of a tubular body coil 129. The region of the tubular body coil 129 adjacent to the first entrance 154 and the second entrance 156 when installed in the magnet are indicated. Near the first entrance 154 is located a single RF power feed 148 that connects to a transmission line 152. The transmission line 152 connects two separate matching networks 150. The two matching networks 150 feed opposite ends of the tubular body coil 129. This helps the body coil produce a more uniform B1 field. The pair of matching networks 150 could for example either be galvanically connected to the tubular body coil 129 at access points or they may be inductive couplings to the tubular body coil 129. For example, if the tubular body coil 129 is a so-called birdcage coil. The dotted lines 200 mark a region where the radiation beam of the radiotherapy system might pass through the tubular body coil 129. The area between the dashed lines 200 indicates regions where the beam may pass. The transmission line 152 in this region is a transmission line formed from a laminated circuit board. In this design, the single RF power feed 148 and the single transmission line 152 feed the tubular body coil at opposite ends. The phase of the RF reaching the pair of matching networks 150 should be identical. This can be achieved by adjusting the length of the transmission line 152 or the control circuitry/software in case of different amplifiers being used for power creation/feeding. The matching networks 150 are outside of the region where the beam passes. They are outside of the region between the lines marked 200.

Fig. 3 shows a tubular body coil 129 and RF feed circuit 146 that is similar to that shown in Fig. 2. The example shown in Fig. 3 has been modified such that there are two RF power feeds 148, 148'. Each of the RF power feeds 148, 148' feeds an individual matching network 150. In this way the phase of the radio-frequency power applied to each of the matching networks 150 can be controlled externally. For example, the transceiver 130 in Fig. 1 may have multiple outputs which have independent and controllable phases. This eliminates the need to tune the length of the transmission line to ensure that the matching networks 150 receive radio-frequency power of the same phase.

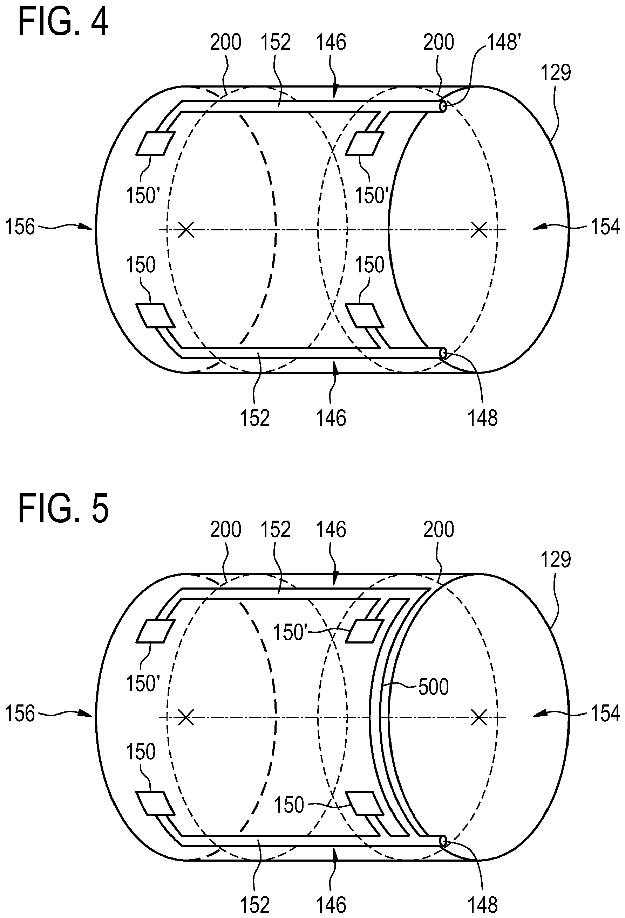

Fig. 4 shows a further example of a tubular body coil 129 and RF feed circuit 146. In the examples shown in Figs. 2 and 3 there is only one pair of matching networks. In the example shown in Fig. 4 there are two separate pairs of matching networks 150, 150'. Each of the pair of matching networks 150' is fed by a separate RF power feed 148, 148'. In this case the pairs of matching networks 150 are located at a 90° angle relative to each other about the circumference of the tubular body coil 129. Adding additional pairs of matching networks 150 may further cause the B1 field generated by the tubular body coil 129 to be more uniform. The phase of the two groups of matching networks 150, 150' could for example be controlled separately by the transceiver by providing separate outputs with controllable phase for the RF power.

Fig. 5 shows a further example of a tubular body coil 129 and an RF feed circuit 146. The example shown in Fig. 5 is a modification of the example illustrated in Fig. 4. Instead of having two RF power feeds there is only a single RF power feed 148. The two groups of matching networks 150, 150' are connected by a connecting transmission line 500. In the example shown in Fig. 5 the length of the transmission lines 500 and 152 may be tuned or adjusted such that the phase for the matching networks 150 match with each other, the phase of the matching networks 150' match with each other and there is an appropriate phase offset between the two groups of matching networks 150, 150'. The connecting transmission line 500 may also be manufactured from the laminated circuit board or it may also be constructed from a conventional transmission line such as a coaxial transmission line. The connecting transmission line 500 is outside of the region which may be directly irradiated by the radiation beam.

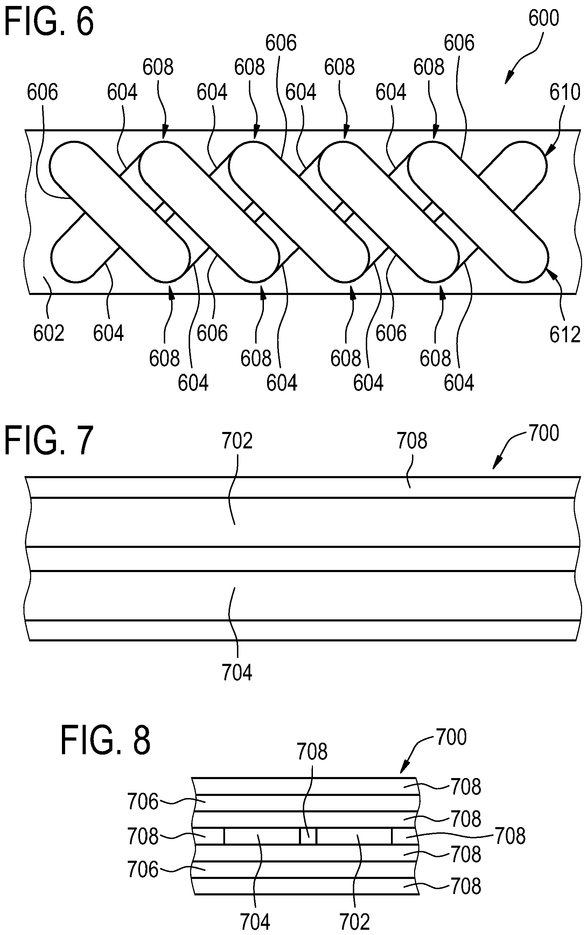

Fig. 6 shows an example of a planar twisted pair 600. The planar twisted pair 600 is also known as an ultra-flat twisted pair. The planar twisted pair 600 is formed from one or more layers of laminate insulator 602 that separates two independent conductive layers. These are shown as the first conductive layer 604 and the second conductive layer 606. These two layers 604, 606 are located at different levels. Periodically these two layers crisscross each other and there is a connection 608 between the layers. This results in a twisted pair that consists of a first conductor 610 and a second conductor 612. The planar twisted pair 600 as illustrated in Fig. 6 may be used for the laminated circuit board to form the at least one transmission line.

In the example of Fig. 6, the conductor width would be around 3 mm (to bear the current with sufficient safety margin due to the losses at e.g. the vias) or about between 1 and 5 mm. If the power is distributed over 4 feeding ports (2 on front and 2 on back side) which is considered a likely implementation. The distance between the conductors would be around 1 mm. The pitch (number of twists per meter) would be around 100 (between 70 and 130) (for the above dimensions more accurately 88 twists per meter).

Figs. 7 and 8 show an alternative to the planar twisted pair 600 of Fig. 6. Figs. 7 and 8 illustrate a symmetric stripline. Fig. 7 shows a top view and Fig. 8 shows a cross-sectional view. In the symmetric stripline 700 there are two ground planes 706. Between the two ground planes 706 there is a first conductor 702 and a second conductor 704. This forms an efficient transmission line. All of the conductive regions 706, 702, 704 are separated by a laminate insulator 708. Due to the required trace width, which can be less than for the twisted pair solution of Fig. 6, since there are no vias required but would still be more than 1mm, the impedance would be less than 50 Ohm, e.g. ∼30 Ohm @ 1mm trace width and 1mm total PCB width. But this can be handled by respectively matched power dividers which are needed to distribute the power over the different feeding ports at the PCB input and the matching circuit to the resonant coil structure itself or matching the amplifier output impedance accordingly.

In Figs. 6, 7 and 8 the conductors could be any one of copper, gold, aluminum, silver, and combinations thereof. The laminate insulator 708, 602 could be any one of the following: Polyimide, Phenolic, Biaxially-oriented polyethylene terephthalate, and combinations thereof.

When connecting the matching and the resulting connection to the birdcage there are three major options)
fixed and directly connected to the birdcage, can be separated PCB or integrated into birdcage coil layout/PCB (good control over connection between matching circuit and coil but requires two connections between screen onto which the power feed (ultra flat twisted pair or stripline) is glued/attached
integrated into polyimide part (makes polyimide part more complex but only one connection between (polyimide part attached to) screen and birdcage is needed as ground can be connected directly from polyimide part to screen)
Integrated into screen (makes screen more complex and damage to matching circuit elements when mounting/bending the screen has to be avoided, but also needs only one connection between bridging the gap between screen and birdcage coil) Generally, option one or two would be preferred.

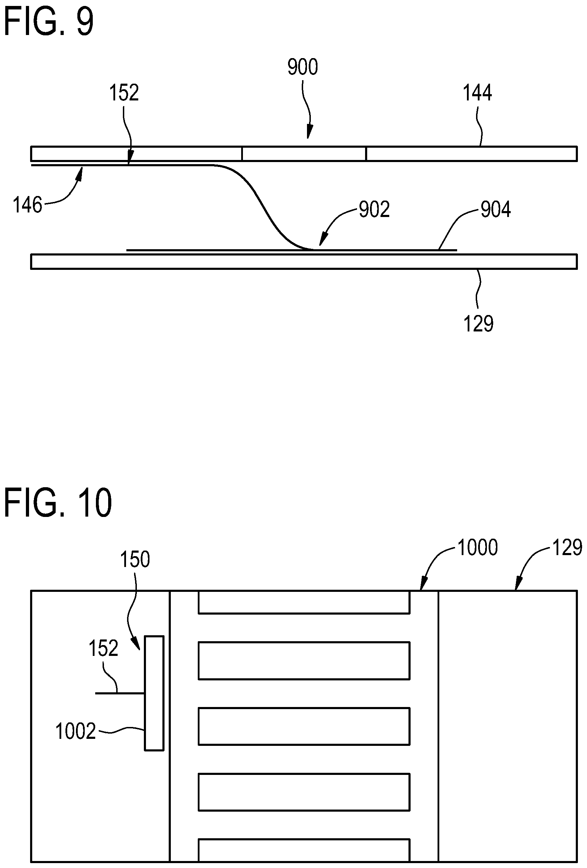

The connection between the screen (e.g. output of the matching or ultra flat cable/stripline depending on the chosen option above or ground connection) would be connected to the birdcage using a "flap", i.e. the flexible end of the polyimide part and soldered through a hole in the RF screen. This is illustrated below in Fig. 9.

Fig. 9 illustrates a means of making a galvanic connection 902 between an RF feed circuit 152 and the tubular body coil 129. In this example it can be seen that the transmission line 152 of the RF feed circuit 146 is attached to the RF shield 144. There is a hole 900 in the RF shield 144 that enables a soldering iron to form a galvanic connection 902 between the transmission line 152 or a portion of the matching network of the RF feed circuit 146 and a conductive element 904 of the tubular body coil 129. The example illustrated in Fig. 9 would for example be useful in connecting a TEM antenna or a birdcage coil to the RF feed circuit 146.

Fig. 10 shows an example of a tubular body coil 129 that is a birdcage coil 1000. In this example the matching network 150 is formed from an inductive loop 1002. The inductive loop 1002 is able to couple the RF power directly into the birdcage coil 1000. The inductive loop 1002 could for example be formed from the same laminated circuit board as is used to make the at least one transmission line 152.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### LIST OF REFERENCE NUMERALS

- 100: medical instrument
- 102: radiotherpay system
- 104: magnetic resonance imaging system
- 106: gantry
- 108: radiotherapy source
- 110: collimator
- 112: magnet
- 114: cryostat
- 116: superconducting coil
- 118: superconducting shield coil
- 122: bore
- 124: magnetic field gradient coil
- 126: magnetic field gradient coil power supply
- 128: magnetic resonance coil
- 129: tubular body coil
- 130: transciever
- 131: detuning circuit
- 132: imaging zone
- 134: subject support
- 136: subject
- 137: mechanical positioning system
- 138: target zone
- 140: axis of gantry rotation
- 142: radiation beam
- 144: RF shield
- 146: RF feed circuit
- 148: RF power feed
- 148: RF power feed
- 150: pair of matching networks
- 150': pair of matching networks
- 152: transmission line
- 154: first entrance
- 156: second entrance
- 160: computer system
- 162: hardware interface
- 164: processor
- 170: computer memory
- 172: machine executable instructions
- 174: pulse sequence commands
- 176: magnetic resonance data
- 178: magnetic resonance image
- 180: radio therapy plan
- 182: radiotherapy system control instructions
- 200: boundary of beam path
- 500: connecting transmission line
- 600: planar twisted pair
- 602: laminate insulator
- 604: first conductive layer
- 606: second conductive layer
- 608: connection between layers
- 610: first conductor of twisted pair
- 612: second conductor of twisted pair
- 700: symmetic strip line
- 702: first conductor
- 704: second conductor
- 706: ground plane
- 708: laminate insulator
- 900: hole in RF screen
- 902: glavanic connection
- 904: conductive element
- 1000: birdcage coil
- 1002: inductive loop

## Claims

1. A medical instrument (100) comprising a magnetic resonance imaging system (104) with an imaging zone (132) and a radiotherapy system (102) configured for irradiating a target zone (138) with a radiation beam (142), wherein the target zone is within the imaging zone, wherein the magnetic resonance imaging system comprises:
a main magnet (112) with a bore (122) for receiving a subject (136), wherein the imaging zone is within the bore, wherein the bore connects a first entrance (154) and a second entrance (156), wherein the radiation beam defines at least one path through the bore;
a magnetic gradient coil (124) within the bore;
a tubular body coil (129) within the bore, wherein the tubular body coil is surrounded by the magnetic gradient coil;
an RF screen (144) between the magnetic gradient coil and the tubular body coil;
an RF system (130) for providing RF power to the tubular body coil;
an RF feed circuit (146) positioned between the tubular body coil and the RF screen, wherein the RF feed circuit is located within the bore, wherein the RF feed circuit comprises one or more RF power feeds (148, 148') adjacent to the first entrance, wherein the RF power feeds are configured for connecting to the RF system, wherein the tubular body coil further comprises one or more pairs of matching networks (150, 150') for coupling the one or more RF power feeds to the tubular body coil, wherein each of the one or more pairs of matching networks comprises a first matching network located between the first entrance and the at least one path and a second matching network located between the second entrance and the at least one path, wherein the RF feed circuit comprises at least one transmission line (152), wherein the at least one transmission line is formed from a laminated circuit board (600, 700), each of the one or more pairs of matching networks is connected by one of the at least one transmission line.

2. The medical instrument of claim 1, wherein the laminated circuit board is formed from a laminate of any one of the following: Polyimide, Phenolic, Biaxially-oriented polyethylene terephthalate, and combinations thereof.

3. The medical instrument of claim 2, wherein the laminated circuit board is further formed from any one of the following: copper, gold, aluminum, sliver, and combinations thereof

4. The medical instrument of any one of the preceding claims, wherein the laminated circuit board if flexible.

5. The medical instrument of any one of the preceding claims, wherein the laminated circuit board is attached to the RF screen.

6. The medical instrument of any one of the preceding claims, wherein the at least transmission line is any one of the following: a planar twisted pair (600) and a symmetric stripline (700).

7. The medical instrument of any one of the preceding claims, wherein each of the one or more pairs of matching networks is coupled to the tubular body coil via a galvanic connection (902).

8. The medical instrument of any one of claim 1 through 6, wherein each of the one or more pairs of matching networks is coupled to the tubular body coil via an inductive coupling (1002).

9. The medical instrument of claim 8, wherein each of the one or more pairs of matching networks comprises an inductive coupling loop (1002) for coupling to the tubular body coil, wherein the inductive coupling loop is formed from the laminated circuit board.

10. The medical instrument of any one of the preceding claims, wherein the tubular body coil is a birdcage coil (1000).

11. The medical instrument of any one of claims 1 through 8, wherein the tubular body coil is a TEM coil.

12. The medical instrument of any one of the preceding claims, wherein the one or more pairs of matching networks is at least partially formed from the laminated circuit board.

13. The medical instrument of claim 12, wherein the one or more pairs of matching networks comprise inductors and/or capacitors, wherein at least a portion of the inductors and/or capacitors are formed from the laminated circuit board.

14. The medical instrument of any one of claims 1 through 11, wherein the one or more pairs of matching networks is connected to the at least one transmission line transmission line via a coaxial cable.

15. The medical instrument of any one of the preceding claims, wherein the radiotherapy system is any one of the following: a LINAC (102), an X-ray therapy system, a charged particle therapy system, a gamma radiation therapy system, and a Cobalt radiation therapy system.
